# FASCICULE DE BREVET EUROPEEN

(11) **EP 1 182 396 B1**
(45) Date de publication et mention de la délivrance du brevet: **14.10.2009**
(21) Numéro de dépôt: 01203099.5
(22) Date de dépôt: 14.08.2001
(51) Int. Cl.: F21V 17/00, F21V 15/00, F21V 19/00, F21V 31/00, F21S 4/00, F21S 8/00, F21V 15/04, F21V 5/00

(54) **Luminaire basé sur l'émission lumineuse de diodes électroluminescentes**
Leuchte auf Leuchtdiodenlichtausstrahlung gestützt
Lamp based on LEDs' light emission

(30) Priorité: 22.08.2000 FR 0010804
(43) Date de publication de la demande: 27.02.2002
(73) Titulaire: Koninklijke Philips Electronics N.V., 5621 BA Eindhoven (NL)
(72) Inventeur: Balestriero, Christophe, 75008 Paris (FR); Flaissier, Marc-Olivier, 75008 Paris (FR)
(74) Mandataire: van Oudheusden-Perset, Laure E.

(56) Documents cités:
- EP-A- 0 596 782
- US-A- 4 070 568
- US-A- 4 829 407
- US-A- 5 335 151

## Description

La présente invention concerne un luminaire incluant un boîtier définissant un espace interne contenant au moins une source de lumière constituée d'une diode électroluminescente (DEL) et des moyens optiques de guidage de la lumière émise par la DEL vers l'extérieur du boîtier, lesdits moyens optiques étant aptes à concentrer la lumière émise par la DEL dans un faisceau.

Un tel luminaire est connu du document WO 98/33007. Ce luminaire, conçu pour l'éclairage de rues, exploite la lumière émise par des DELs : les moyens optiques de guidage utilisés assurent d'une part, la concentration de l'intensité produite par la DEL dans un faisceau et, d'autre part, la directivité du faisceau.

La caractéristique d'émission d'une DEL présente une forme particulière. Les moyens optiques, mettant en oeuvre les principes de l'optique physique, présentent une géométrie qui permet des performances optimales pour une position précise et constante des moyens optiques par rapport à la caractéristique d'émission de la DEL. Le luminaire étant destiné à être transporté puis installé, la robustesse du montage des moyens optiques par rapport au support de la DEL doit être garantie pour que les luminaires conservent les propriétés annoncées par le fabricant.

Dans le document WO 98/33007, la DEL est fixée à l'intérieur des moyens optiques qui sont eux-mêmes fixés au boîtier. La réalisation de ce montage nécessite des manipulations délicates de la DEL. Or, les DELs sont très sensibles aux manipulations mécaniques : leur durée de vie et leurs performances lumineuses dépendent du soin apporté à leur manipulation, notamment lors de leur montage au sein d'un luminaire conforme au paragraphe introductif. La DEL possède, entre autres, un dôme fragile sur lequel ne doivent pas s'exercer de contraintes importantes. Un montage délicat, comme celui proposé par le document WO 98/33007 est donc à éviter. De plus, ce montage demande du temps et est coûteux en opérations automatisées.

Le document EP 0 596 782 A divulgue un luminaire selon le préambule de la revendication 1.

C'est un objet de l'invention de résoudre dans une large mesure le problème du montage des moyens optiques par rapport à la DEL, au sein du luminaire.

Un luminaire conforme au paragraphe introductif est remarquable selon l'invention en ce que la DEL est montée sur un support lié au boîtier et en ce que les moyens optiques sont maintenus entre un élément de maintien lié au boîtier et le support de la DEL.

Le montage ainsi réalisé consiste à poser les moyens optiques sur le support de la DEL et à utiliser un élément de maintien lié au boîtier pour les maintenir. Ce montage présente l'avantage de ne pas exiger de manipulations délicates de la DEL qui peut être pré-installée sur son support, d'être rapide et de pouvoir être aisément automatisé.

Dans un mode de réalisation de l'invention, les moyens optiques sont maintenus de manière élastique entre l'élément de maintien lié au boîtier et le support de la DEL par des moyens de maintien élastique. Lesdits moyens de maintien élastique exercent alors une pression sur les moyens optiques à l'aide de l'élément de maintien lié au boîtier. Par conséquent, les moyens optiques exercent une pression sur le support de la DEL. Ainsi, les jeux mécaniques qui peuvent exister entre l'élément de maintien lié au boîtier et les moyens optiques et entre les moyens optiques et le support de la DEL sont rattrapés et ceci empêche les mouvements relatifs des moyens optiques par rapport au support de la DEL. Les formes des moyens optiques et celle du support de la DEL sont avantageusement adaptées de manière à ce que, sous pression, le contact entre les moyens optiques et le support de la DEL participe à garantir une position précise et constante donnant des performances optimales à l'ensemble. Dans une mise en oeuvre préférée de l'invention, les moyens de maintien élastique des moyens optiques sont réalisés par un bloc de matériau élastique placé de manière à être compressé entre l'élément de maintien lié au boîtier et les moyens optiques. Ledit matériau élastique peut notamment appartenir à tous types de mousses. Cette solution présente l'avantage d'être simple à mettre en oeuvre et de permettre de contrôler l'intensité de la pression exercée par les moyens optiques sur le support de la DEL par choix des caractéristiques du matériau élastique utilisé.

Dans une mise en oeuvre avantageuse de l'invention, un matériau de coefficient d'adhérence faible est placé entre les moyens optiques et l'élément de maintien lié au boîtier. Ce matériau réalise le contact entre les moyens optiques et, soit l'élément de maintien des moyens optiques, soit les moyens de maintien élastique. L'effet de ce matériau de coefficient d'adhérence faible, qui peut être du polyéthylène, est de faciliter les mouvements relatifs de translation au niveau du contact entre les moyens optiques et, soit l'élément de maintien lié au boîtier, soit les moyens de maintien élastique. Des mouvements de translation de l'élément de maintien lié au boîtier ou des moyens de maintien élastique, par rapport au boîtier sur lequel est fixé le support de la DEL peuvent en effet entraîner les moyens optiques qui, dans ce cas, se décalent de leur position de performances optimales par rapport à la caractéristique d'émission de la DEL. Ces mouvements de translation, desquels résultent des glissements au niveau des contacts entre objets, peuvent être le résultat d'une contrainte mécanique extérieure comme celui de différences de dilatations thermiques entre matériaux différents. En effet, dans cet environnement où se trouvent des objets réalisés en matériaux différents et où la température est amenée à varier fortement, les différences de dilatations sont des sources de mouvements relatifs entre lesdits objets, mouvements qui peuvent ne pas être négligeables.

Dans un mode de réalisation avantageux de l'invention, l'élément de maintien lié au boîtier est lié au boîtier par des moyens de collage. Cette solution permet d'éviter l'utilisation de vis.

Les vis sont d'usage courant dans le domaine des luminaires mais posent des problèmes du point de vue des différences de dilatation quand les matériaux fixés sont différents, ce qui est généralement le cas pour un luminaire conforme au paragraphe introductif. Un avantage supplémentaire est de permettre une miniaturisation plus importante du luminaire qu'avec des vis, car l'emploi de moyens de collage requiert une certaine surface mais n'occupe pas d'espace matériel important.

Dans un mode de réalisation particulier de l'invention, les moyens de collage sont des bandes adhésives.

Dans un mode de réalisation particulièrement avantageux de l'invention, l'élément de maintien lié au boîtier est une plaque transmettant la lumière. Cette disposition est adoptée avantageusement lorsque la plaque transmettant la lumière est superposée aux moyens optiques car, dans ce cas, elle remplit deux fonctions : protéger les moyens optiques, généralement fragiles, et maintenir lesdits moyens optiques.

L'invention sera mieux comprise à la lumière de la description suivante de quelques modes de réalisation, faite à titre d'exemple et en regard des dessins annexés, dans lesquels :
- la figure 1 est une section représentant un exemple de luminaire conforme à l'invention,
- la figure 2 est une vue en perspective éclatée d'un autre exemple de luminaire mettant en oeuvre l'invention,
- la figure 3 est une vue partielle de dessus d'une réalisation améliorée du luminaire de la figure 2,
- La figure 4 est une vue en perspective d'une pièce d'ajustement de jeux mécaniques mise en oeuvre dans un mode particulier de réalisation de invention du type des figures 2 et 3.

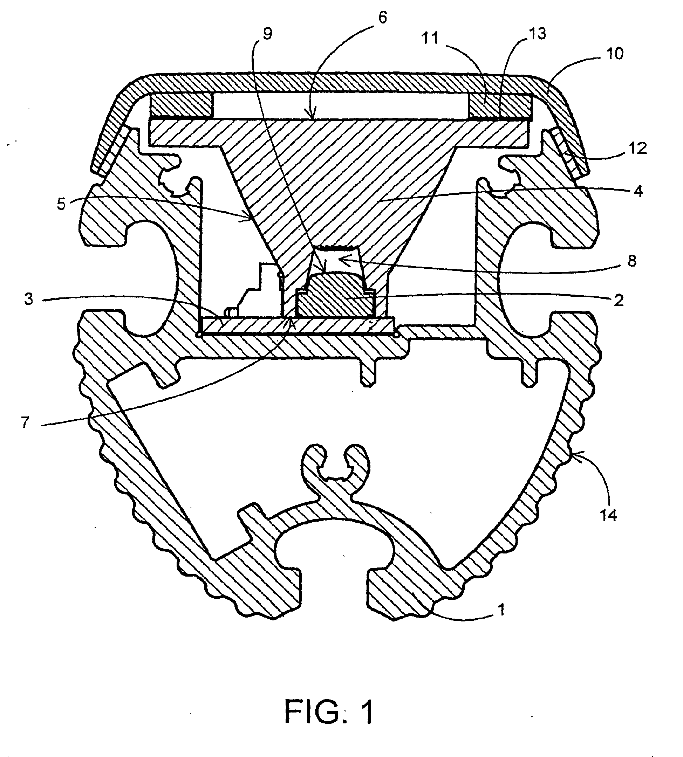

La figure 1 présente une section d'un luminaire selon un mode de réalisation avantageux de l'invention. Cette figure n'est qu'indicative d'un mode de réalisation.

Ce luminaire inclut un boîtier 1 contenant une source de lumière constituée d'une diode électroluminescente (DEL) 2 montée sur un support 3 fixé au boîtier 1. Le support 3 de la DEL est un circuit imprimé et la fixation dudit support 3 au boîtier 1 peut par exemple être réalisée par des moyens de collage. L'utilisation de moyens de collage, par exemple une bande adhésive, présente l'avantage de participer à une évacuation correcte de la chaleur. Les moyens de collage possèdent, en effet, de bonnes propriétés de conduction thermique et permettent d'avoir une surface de contact maximale entre le support 3 et le boîtier 1. Dans l'exemple de réalisation décrit ici, le support 3 est plan mais cela n'exclut pas d'autres géométries du support 3.

Les moyens optiques comprennent ici un collimateur 4 constitué en masse d'un matériau transmettant la lumière et résistant à la température, par exemple du Polyméthacrylate de Méthyle (PMMA). Les moyens optiques sont ici un collimateur 4 "plein" mais ils peuvent aussi être constitués, par exemple, d'un réflecteur creux conique. Le collimateur 4 présente une surface latérale 5 à symétrie de révolution de base parabolique ou conique, une surface frontale 6 plane ici et une surface formant une base 7, géométriquement opposée à la surface frontale 6. La base 7 est ici plane mais cette caractéristique n'exclut pas d'autres géométries. La surface latérale 5 du collimateur 4 permet à la lumière émise par la DEL 2 d'être concentrée dans un faisceau. Ici, le faisceau obtenu est un faisceau directif de lumière constitué de rayons parallèles. Ce faisceau de lumière sort du collimateur 4 par la surface frontale 6 et la direction dudit faisceau est perpendiculaire au plan défini par cette surface frontale 6. La caractéristique d'émission du système comprenant la DEL 2 et le collimateur 4 présente donc ici une direction d'émission maximum qui est, dans cet exemple, perpendiculaire au plan défini par la surface frontale 6 du collimateur 4.

Le collimateur 4 présente, de plus, dans sa base 7, un évidement 8 prévu pour accueillir la DEL 2. Le collimateur 4 est posé par-dessus la DEL 2. La DEL étant sensible aux pressions qui peuvent s'exercer sur son dôme 9, les contacts qui peuvent exister entre la DEL 2 et le collimateur 4 sont minimisés par surdimensionnement des cotes de l'évidement 8 et le collimateur 4 repose par sa base 7 sur le support 3 où est montée la DEL 2.

Les performances lumineuses optimales du collimateur 4, c'est-à-dire, le contrôle de la structure du faisceau et de sa puissance, sont obtenues pour une position précise du collimateur 4 par rapport à la caractéristique d'émission de la DEL 2. Ici, un décalage latéral par translation de la base 7 du collimateur 4 par rapport à la DEL 2 supérieur à 4 % du diamètre de la DEL entraîne une perte d'efficacité supérieure à 10 %. Les jeux sur les cotes de la base 7 du collimateur 4 ainsi que sur les cotes de l'évidement 8 sont donc ici calculés pour que les translations latérales du collimateur 4 par rapport à la DEL 2 restent d'ampleur suffisamment petite pour garantir de bonnes performances lumineuses en sortie du collimateur 4. Ces cotes tiennent aussi compte de la nécessité de ne pas imposer de contraintes latérales importantes à la DEL 2.

Poser le collimateur 4 sur le support 3 de la DEL 2 permet, par les cotes réalisées sur les différents éléments, d'assurer un premier positionnement qui sera maintenu par l'élément de maintien lié au boîtier 1. Cet élément de maintien est, dans ce mode de réalisation, une plaque 10 transmettant la lumière : la plaque 10 transmettant la lumière est ainsi superposée au collimateur 4 en compressant un bloc de matériau élastique 11. La plaque 10 est liée au boîtier 1 par une bande adhésive 12 double face. Le collimateur 4, instrument optique fragile, est ainsi protégé par la plaque transmettant la lumière 10 des agressions extérieures qui peuvent l'endommager et nuire à ses performances optiques. L'utilisation de moyens de collage, tels que la bande adhésive 12, a aussi l'avantage de participer à l'étanchéité du luminaire. Etant donné que le boîtier 1 et la plaque 10 sont a priori réalisés en matériaux différents et donc soumis à des différences de dilatation, l'utilisation de moyens de collage, tels une bande adhésive 12, dont les propriétés de résistance au cisaillement peuvent être judicieusement choisies, est aussi une solution pour permettre les mouvements relatifs du boîtier 1 et de la plaque 10.

Dans cet exemple, le bloc de matériau élastique 11 est apposé sur la surface frontale 6 du collimateur 4. Le matériau élastique peut être choisi parmi tous les types de mousse, de différentes densités et de différentes formes en fonction de l'intensité de la pression que l'on souhaite exercer sur le collimateur 4 pour le maintenir en place. Dans un exemple de réalisation, le bloc de matériau élastique 11 était constitué de mousse adhésive simple face en vinyle de densité 225 kg/m³, de 6 mm d'épaisseur et de 3 mm de largeur. De nombreuses variantes de l'invention sont possibles concernant le maintien élastique des moyens optiques ainsi que le positionnement des moyens de maintien élastique relativement aux autres éléments du luminaire : la mise en oeuvre de ressorts est par exemple envisageable ; placer les moyens de maintien élastique entre le support de la DEL et une surface appartenant au boîtier lui-même, qui est alors l'élément de maintien lié au boîtier, est aussi une solution possible en accord avec l'invention.

Ici, le collimateur 4 est construit de manière à présenter une efficacité optimale lorsque le contact du collimateur 4 est planaire avec le support 3 de la DEL 2. Rompre le contact planaire entre le collimateur 4 et le support 3 de la DEL 2 revient à réaliser un mouvement de rotation par rapport à une famille d'axes perpendiculaire à la direction d'émission maximum de la caractéristique d'émission du système comprenant la DEL 2 et le collimateur 4. Dans le cas décrit ici, une rotation du collimateur de plus de 3 par rapport à un de ces axes engendre une perte sur l'intensité maximale de 10 %. Ces mouvements de rotation ne peuvent se produire que s'il existe un jeu dans une direction proche de la direction d'émission maximale d'émission du système comprenant la DEL 2 et le collimateur 4, entre les divers éléments que sont le support 3 de la DEL, le collimateur 4 et la plaque 10 transmettant la lumière. Le matériau élastique 11, moyen de maintien élastique, exerce une pression sur le collimateur dont le contact planaire avec le support 3 de la DEL est alors forcé. Etant donné qu'alors, le maintien élastique du collimateur évite la présence de ces jeux, ces rotations sont empêchées.

Un ruban 13 de polyéthylène, matériau de coefficient d'adhérence faible, est inséré entre les moyens de maintien élastique qu'est le bloc de matériau élastique 11 et les moyens optiques qu'est le collimateur 4 et permet des mouvements de translation dus aux différences de dilatation entre les divers éléments construits à partir de matériaux différents. En particulier, la pression exercée sur le collimateur 4 par le bloc de matériau élastique 11 pourrait bloquer, en l'absence de ce matériau de coefficient d'adhérence faible, lesdits mouvements de translation et donc générer un entraînement du collimateur dans les mouvements de la plaque 10 transmettant la lumière et liée au boîtier 1. La présence du ruban 13 de polyéthylène, matériau de coefficient d'adhérence faible, libère les mouvements de translation du matériau élastique 11 par rapport au collimateur 4 et évite ainsi les mouvements du collimateur 4 par rapport au support 3 de la DEL 2.

Le boîtier 1 est avantageusement réalisé en matériau conducteur de chaleur, par exemple de l'aluminium anodisé, et sa surface externe présente une surface ondulée 14. Lors de son fonctionnement, la DEL 2 émet de la chaleur. Or, les performances optimales d'une DEL en terme de flux de lumière principalement, nécessitent une température contrôlée : la chaleur émise par la DEL 2 doit donc être évacuée. Le matériau conducteur de chaleur permettra d'évacuer la chaleur vers l'extérieur et la surface ondulée augmente l'efficacité de ce radiateur.

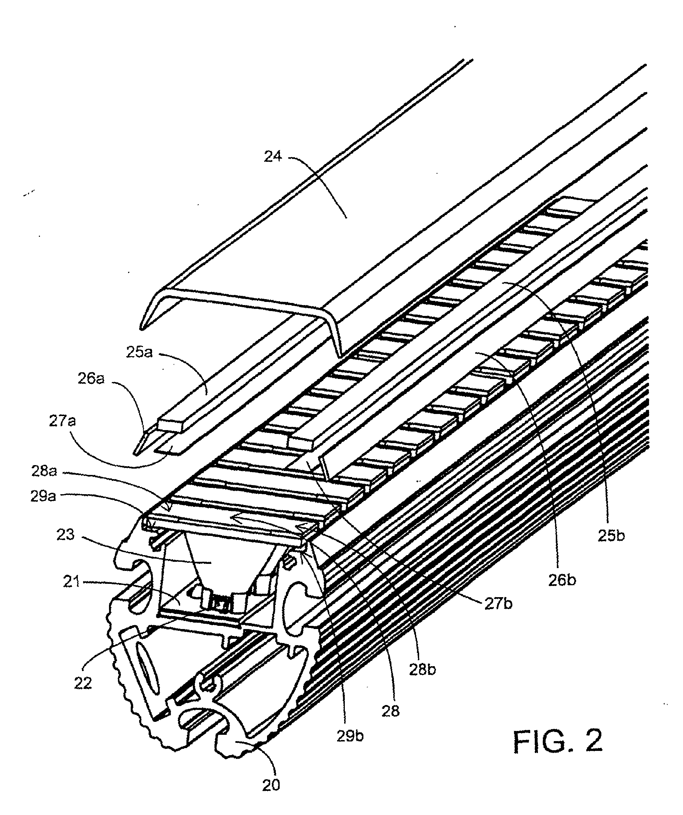

La figure 2 décrit une mise en oeuvre de l'invention au sein d'un luminaire incluant plusieurs DEL pour lesquelles les moyens optiques sont fixés conformément à l'invention. L'augmentation du nombre de DELs impose une augmentation de la taille du luminaire et, de ce fait, les mouvements dus aux différences de dilatation entre matériaux différents ont donc plus d'ampleur. L'invention trouve dans ce cas une application particulièrement intéressante.

Dans un boîtier 20, est fixé un support 21 présentant un certain nombre de DELs 22. Sur chacune des DELs 22, un collimateur 23 est aligné et posé sur le support 21. Dans une mise en oeuvre particulière de l'invention, plusieurs collimateurs 23 peuvent aussi être groupés en une seule pièce posée sur le support 21, les collimateurs étant chacun centré sur une DEL 22. Une plaque 24 transmettant la lumière est superposée à l'ensemble des collimateurs 23 en compressant deux bandes de matériau élastique 25a et 25b. La plaque 24 est liée au boîtier 20 par deux bandes adhésives double face 26a et 26b. Deux rubans 27a et 27b de polyéthylène, matériau de coefficient d'adhérence faible, sont insérés entre les collimateurs 23 et les bandes de matériau élastique 25a et 25b et permettent des mouvements de translation dus aux différences de dilatation entre les divers éléments, que sont la plaque 24 et le boîtier 20, construits à partir de matériaux différents.

Dans cet exemple, la mise en oeuvre de plusieurs ensembles constitués d'une DEL et de ses moyens optiques exige que les performances lumineuses de chacun de ces ensembles constitués d'une DEL et de ses moyens optiques soient homogènes. Des différences de performances lumineuses entre les différents ensembles, nuiraient à l'esthétique du résultat et/ou à son efficacité. Or, la fixation en position optimale des moyens optiques par rapport aux caractéristiques d'émission des DELs est particulièrement importante pour garantir l'homogénéité des performances lumineuses de chacun des ensembles constitués d'une DEL et de ses moyens optiques. Garantissant un positionnement optimal et individuel des moyens optiques par rapport à la caractéristique d'émission de chacune des DELs, l'invention permet d'envisager des éclairages uniformes de diverses formes, basés sur l'émission de plusieurs DELs.

Les collimateurs 23 présentent, dans cet exemple, une surface frontale 28 rectangulaire et élargie de manière à dépasser la surface stricte de sortie du faisceau lumineux. Cette surface frontale 28 élargie sert de surface d'appui aux deux bandes de matériau élastique 25a et 25b qui sont placées sur les côtés 28a et 28b de la surface frontale 28 de manière à ne pas réduire le flux lumineux.

Leur surface frontale 28 étant rectangulaire, les collimateurs 23 ne présentent pas de symétrie de révolution. On pourra pour des raisons esthétiques vouloir alors empêcher une rotation par rapport à un axe perpendiculaire au plan défini par la surface frontale 28 des collimateurs 23. Cette rotation est encore plus particulièrement nuisible quand les moyens optiques ne sont pas de symétrie de révolution afin d'avoir un faisceau en sortie qui n'est pas non plus de symétrie de révolution : ladite rotation affecte alors les propriétés lumineuses du luminaire. Cette rotation peut être limitée par des épaulements 29a et 29b pratiqués sur le boîtier 20. Cependant, dans le mode de réalisation présenté sur la figure 2, compte tenu des procédés industriels utilisés pour la fabrication du boîtier, qui est ici en aluminium extrudé, il est difficile de contrôler le jeu existant entre les collimateurs 23 et les épaulements 29a et 29b. Ladite rotation n'est alors que grossièrement limitée.

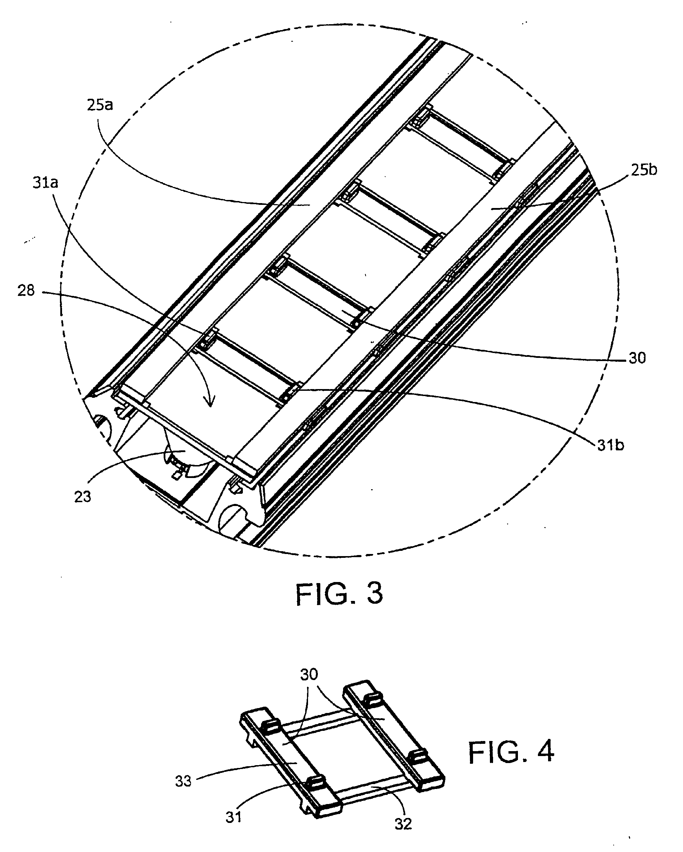

Sur la figure 3 est présentée une vue partielle de dessus d'une réalisation améliorée du luminaire de la figure 2, vue dans laquelle les mêmes références désignent les mêmes parties que sur la figure 2. L'amélioration consiste à limiter l'ampleur du mouvement en rotation des collimateurs 23 par rapport à un axe perpendiculaire au plan défini par la surface frontale 28 du collimateur 23. Des pièces rigides 30 sont, à cet effet, insérées entre les différentes surfaces frontales 28 des collimateurs 23. Ces pièces rigides 30 possèdent des cotes calculées de manière à ce qu'il existe des jeux entre lesdites pièces rigides 30 et les collimateurs 23. En effet, la présence des pièces rigides 30 doit permettre de limiter l'ampleur de la rotation des collimateurs 23 sans rigidifier l'ensemble des collimateurs 23 qui doivent chacun rester indépendant pour ne pas générer de contraintes sur les DELs 22. Dans cet exemple, la forme la plus adaptée pour ces pièces rigides 30 est une forme parallélépipédique qui comble l'espace vide existant entre deux surfaces frontales 28 de deux collimateurs 23 mais cette forme n'est pas exclusive et peut être de diverses sortes de manière à s'adapter à la géométrie du luminaire et/ou à celle des moyens optiques. Lesdites pièces rigides 30 peuvent être mises en oeuvre en combinaison avec l'invention ou indépendamment de l'invention.

Deux bossages 31a et 31b sont avantageusement situés sur chacune des pièces rigides 30 pour servir de butée aux bandes de matériau élastique 25a et 25b et aux rubans de polyéthylène 26a et 26b montrés sur la figure 2. Cela empêche que ces éléments viennent recouvrir la partie de la surface frontale 28 des collimateurs 23 par laquelle sort le faisceau de lumière. Lesdits bossages 31a et 31b pourraient, dans un autre mode de réalisation, être réalisés sur la surface frontale 28 des collimateurs 23.

La figure 4 représente un exemple de mode de réalisation particulier des pièces rigides 30. Lesdites pièces rigides 30, parallélépipédiques, insérées entre les différentes surfaces frontales 28 des collimateurs 23 sont ici groupées par plusieurs, deux par exemple, dans une seule pièce d'ajustement des jeux 33 grâce à un élément de liaison 32 qui fait corps avec l'ensemble des deux pièces rigides 30 parallélépipédiques. Ladite pièce d'ajustement des jeux 33 peut être, par exemple, réalisée par moulage dans tout type de matériau rigide. Le moulage est particulièrement avantageux car il permet de réaliser facilement les bossages 31.

La forme particulière de cet exemple de pièce d'ajustement des jeux 33 permet de limiter les mouvements des pièces rigides 30 entre les collimateurs 23 qui pourraient s'effectuer dans le cas de pièces rigides 30 indépendantes.

## Revendications

1. Luminaire incluant un boîtier (1) définissant un espace interne contenant au moins une source de lumière (2) constituée d'une diode électroluminescente (DEL) montée sur un circuit imprimé et des moyens optiques de guidage (4) de la lumière émise par la DEL vers l'extérieur du boîtier, lesdits moyens optiques étant aptes à concentrer la lumière émise par la DEL (2) dans un faisceau et maintenus entre un élément de maintien (10) lié au boîtier (1) et le circuit imprimé (3), **caractérisé en ce que** le circuit imprimé (3) est fixé au boîtier.

2. Luminaire selon la revendication 1 **caractérisé en ce que** les moyens optiques sont maintenus de manière élastique entre l'élément de maintien lié au boîtier et le circuit imprimé par des moyens de maintien élastique (11).

3. Luminaire selon la revendication 2, **caractérisé en ce que** les moyens de maintien élastique des moyens optiques sont réalisés par un bloc de matériau élastique placé de manière à être compressé entre l'élément de maintien lié au boîtier et les moyens optiques.

4. Luminaire selon l'une quelconque des revendications 1 à 3, **caractérisé en ce qu'**un matériau de coefficient d'adhérence faible (13) est placé entre les moyens optiques et l'élément de maintien lié au boîtier.

5. Luminaire selon l'une quelconque des revendications 1 à 4, **caractérisé en ce que** l'élément de maintien lié au boîtier est lié au boîtier par des moyens de collage (12).

6. Luminaire selon la revendication 5, **caractérisé en ce que** les moyens de collage sont des bandes adhésives.

7. Luminaire selon l'une quelconque des revendications 1 à 6, **caractérisé en ce que** l'élément de maintien lié au boîtier est une plaque transmettant la lumière.

## Claims

1. Luminaire comprising a housing (1) that defines an internal space that contains at least one light source (2) formed by a light emitting diode (LED) mounted on a printed circuit and optical waveguide means (4) for guiding the light emitted by the LED to the exterior of the housing, which optical waveguide means are designed to concentrate the light emitted by the LED (2) into a beam and are held between a retaining element (10) connected to the housing (1) and the printed circuit (3), **characterized in that** the printed circuit (3) is fixed to the housing (1).

2. Luminaire as claimed in claim 1, **characterized in that** the optical waveguide means are held in an elastic manner between the retaining element connected to the housing and the printed circuit by elastic retaining means (11).

3. Luminaire as claimed in claim 2, **characterized in that** the elastic retaining means of the optical waveguide means are implemented as a block of elastic material that is placed such that it is compressed between the retaining element connected to the housing and the optical waveguide means.

4. Luminaire as claimed in any one of the claims 1 to 3, **characterized in that** a material (13) with a low adhesion coefficient is arranged between the optical waveguide means and the retaining element connected to the housing.

5. Luminaire as claimed in any one of the claims 1 to 4, **characterized in that** the retaining element connected to the housing is connected to the housing by adhesive means (12).

6. Luminaire as claimed in claim 5, **characterized in that** said adhesive means are formed by adhesive tapes.

7. Luminaire as claimed in any one of the claims 1 to 6, **characterized in that** the retaining element connected to the housing is formed by a plate that transmits light.

## Patentansprüche

1. Beleuchtungskörper, umfassend ein Gehäuse (1), das einen Innenraum definiert, der mindestens eine Lichtquelle (2), die aus einer Leuchtdiode (LED) besteht, die auf einer gedruckten Schaltung angebracht ist, und optische Mittel (4) zum Leiten des Lichts, das von der LED aus dem Gehäuse heraus ausgestrahlt wird, enthält, wobei die optischen Mittel dazu geeignet sind, das von der LED (2) ausgestrahlte Licht in einem Bündel zusammenzuführen, und zwischen einem Halteelement (10), das mit dem Gehäuse (1) verbunden ist, und der gedruckten Schaltung (3) gehalten werden, **dadurch gekennzeichnet, dass** die gedruckte Schaltung (3) an dem Gehäuse befestigt ist.

2. Beleuchtungskörper nach Anspruch 1, **dadurch gekennzeichnet, dass** die optischen Mittel zwischen dem mit dem Gehäuse verbundenen Halteelement und der gedruckten Schaltung durch elastische Haltemittel (11) elastisch gehalten werden.

3. Beleuchtungskörper nach Anspruch 2, **dadurch gekennzeichnet, dass** die elastischen Haltemittel der optischen Mittel durch einen Block aus elastischem Material ausgebildet werden, der derart angeordnet ist, dass er zwischen dem mit dem Gehäuse verbundenen Halteelement und den optischen Mitteln zusammengedrückt wird.

4. Beleuchtungskörper nach einem der Ansprüche 1 bis 3, **dadurch gekennzeichnet, dass** ein Material mit geringem Haftwert (13) zwischen den optischen Mitteln und dem mit dem Gehäuse verbundenen Halteelement angeordnet ist.

5. Beleuchtungskörper nach einem der Ansprüche 1 bis 4, **dadurch gekennzeichnet, dass** das mit dem Gehäuse verbundene Halteelement durch Klebemittel (12) mit dem Gehäuse verbunden ist.

6. Beleuchtungskörper nach Anspruch 5, **dadurch gekennzeichnet, dass** die Klebemittel Klebebänder sind.

7. Beleuchtungskörper nach einem der Ansprüche 1 bis 6, **dadurch gekennzeichnet, dass** das mit dem Gehäuse verbundene Halteelement eine Licht übertragende Platte ist.
